(19) Europäisches Patentamt
European Patent Office
Office européen des brevets

(11) **EP 2 569 864 B1**

(12) **EUROPÄISCHE PATENTSCHRIFT**

(45) Veröffentlichungstag und Bekanntmachung des Hinweises auf die Patenterteilung:
**21.08.2019   Patentblatt 2019/34**

(21) Anmeldenummer: **11714767.8**

(22) Anmeldetag: **14.04.2011**

(51) Int Cl.:
*H03K 19/177* (2006.01)   *H03L 7/181* (2006.01)

(86) Internationale Anmeldenummer:
**PCT/EP2011/055947**

(87) Internationale Veröffentlichungsnummer:
**WO 2011/151103 (08.12.2011 Gazette 2011/49)**

(54) **SCHALTUNG ZUR TAKTUNG EINES FPGA**

CIRCUIT FOR CLOCKING AN FPGA

CIRCUIT POUR CADENCER UN FPGA

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.05.2010   DE 102010028963**

(43) Veröffentlichungstag der Anmeldung:
**20.03.2013   Patentblatt 2013/12**

(73) Patentinhaber: **Endress+Hauser SE+Co. KG 79689 Maulburg (DE)**

(72) Erfinder:
• **SCHLACHTER, Marc
79664 Wehr (DE)**
• **GIRARDEY, Romuald
F-68330 Huningue (FR)**

(74) Vertreter: **Andres, Angelika Maria et al
Endress+Hauser (Deutschland) AG+Co. KG
PatServe
Colmarer Strasse 6
79576 Weil am Rhein (DE)**

(56) Entgegenhaltungen:
**WO-A1-2008/132583      WO-A1-2008/144917
US-A- 5 459 435**

**EP 2 569 864 B1**

**Beschreibung**

Die vorliegende Erfindung betrifft eine Schaltung zur Taktung eines FPGA. FPGA mit geringer Leistungsaufnahme sind bekannt. In der Messtechnik wären beispielsweise FPGA eingesetzt, welche eine Stromaufnahme von etwa 80 μA aufweisen. Andererseits erfordern Anwendungen in der Messtechnik beispielsweise einen genauen Takt, d. h. die Abweichungen von der Grundfrequenz sollten nicht mehr als +/- 0.1 % bzw. +/- 0.2% betragen. Solch ein genauer Takt kann durch handelsübliche Oszillatoren mit geringer Leistungsaufnahme nicht bereitgestellt werden. Es wäre möglich, ein sehr genaues Taktsignal durch eine in den FPGA integrierte PLL-Schaltung zu generieren, welche basierend auf einem externen Referenztakt einen schnelleren Takt erzeugt. Solche PLL-Schaltungen haben jedoch den Nachteil, dass ihre Leistungsaufnahme zu groß ist. So beträgt der typische Stromverbrauch etwa 1 mA, also etwa das 12-fache der oben erwähnten Stromaufnahme des FPGA an sich. Dies macht die Bereitstellung eines Systemtakts mittels einer integrierten PLL-Schaltung unattraktiv.

Die Veröffentlichung WO 2008/144917 A1 offenbart ebenfalls eine Schaltung zur Steuerung eines lokalen Oszillators, dessen Frequenz mit einem Referenzoszillator durch Zählervergleich überwacht wird. Die konkrete Einstellung der Frequenz des lokalen Oszillators erfolgt durch von einem Controller mittels eines Frequenzanpassungssignals. Weitere Einzelheiten dazu sind nicht genannt.

Die Veröffentlichung WO 2008/132583 A1 offenbart eine Schaltung zur Steuerung eines digitalen Frequenzsynthesizers über eine FLL-Schaltung. Der digitale Frequenzsynthesizer erhält digitale Steuersignale von einem digitalen Komparator, der Zählerstände vergleicht:

US Patent Nr. 5, 459,435 offenbart eine Schaltung zur Steuerung eines programmierbaren Oszillators (VCO), dessen Frequenz mit einem Referenzoszillator durch Zählervergleich mit einem Referenzzähler überwacht wird. Die tatsächliche Einstellung der Frequenz des programmierbaren Oszillators (VCO) erfolgt über einen D/A-Wandler.

Es ist daher die Aufgabe der vorliegenden Erfindung, eine Schaltung mit einer verbesserten Steuerung des Oszillators bereitzustellen.

Die Aufgabe wird erfindungsgemäß gelöst durch die Schaltung gemäß dem unabhängigen Patentanspruch 1.

Die erfindungsgemäße Schaltung, umfasst einen FPGA, welcher eine FLL-Schaltung aufweist; einen Referenztaktgeber einer ersten Frequenz oder einen Referenztakteingang zum Empfang eines Referenztakts einer ersten Frequenz;

einen programmierbaren Oszillator, welcher ein Taktsignal für den FPGA ausgibt, wobei die FLL-Schaltung dazu ausgelegt ist, eine erste Zahl von Taktsignalen des programmierbaren Oszillators während einer zweiten Zahl von Perioden des Referenztakts zu erfassen, wobei die erste Zahl größer ist als die zweite Zahl, und ein Rückkopplungssignal auszugeben, um das Verhältnis zwischen der ersten Zahl und der zweiten Zahl zu steuern, indem das Rückkopplungssignal auf die Frequenz des programmierbaren Oszillators einwirkt, wobei die Frequenz des programmierbaren Oszillators über mindestens einen Widerstandswert gesteuert wird, auf welchen das Rückkopplungssignal einwirkt, wobei der Widerstandswert einstellbar ist über eine Serie von Einzelwiderständen, die zur Verringerung des Widerstands zumindest teilweise selektiv in Bezug auf Schaltungsmasse überbrückbar sind.

In einer Weiterbildung der Erfindung ist die Frequenz des programmierbaren Oszillators durch das Rückkopplungssignal um nicht mehr als 5 %, insbesondere nicht mehr als 2 % und vorzugsweise nicht mehr als 1 % variierbar.

In einer derzeit bevorzugten Weiterbildung der Erfindung wird die Zahl der Taktsignale des programmierbaren Oszillators während einer Periode des Referenztakts erfasst. In diesem Fall ist die zweite Zahl also 1. Selbstverständlich kann die zweite Zahl auch andere Werte annehmen, beispielsweise 2, 3, 4 oder 5.

Das Verhältnis zwischen der ersten Zahl und der zweiten Zahl weist insbesondere einen vorgegebenen oder vorgebbaren Sollwert auf, welcher größer als 10:1, vorzugsweise größer als 100:1 und besonders bevorzugt nicht weniger als 500:1 ist.

Die Frequenz des programmierbaren Oszillators wird gemäß der Erfindung über mindestens einen Widerstandswert gesteuert, auf welchen das Rückkopplungssignal einwirkt.

Gemäß der Erfindung trägt die Serie der selektiv überbrückbaren Widerstände nicht mehr als 10 % zum gesamten Wert des Widerstands bei. Die Serie von überbrückbaren Einzelwiderständen umfasst erfindungsgemäß mindestens 10 und bevorzugt mindestens 20 Einzelwiderstände.

Die Serie von Einzelwiderständen umfasst gemäß einer Weiterbildung der Erfindung mindestens ein Widerstandselement mit einem variablen Widerstandswert. Der variable Widerstandswert kann dabei insbesondere zwischen einem Minimalwert und einem Maximalwert variiert werden, wobei insbesondere für den Fall, dass die überbrückbaren Widerstandselemente alle den gleichen Widerstandswert aufweisen, der Maximalwert gleich dem Widerstandswert der überbrückbaren Widerstandselemente entspricht. Der Minimalwert ist möglichst gering, insbesondere beträgt er weniger als 5%, vorzugsweise weniger als 2% und besonders bevorzugt weniger als 1% des Maximalwerts. Auf diese Weise lässt sich der Gesamtwert des Widerstands, welche den programmierbaren Oszillator steuert, durch selektives Überbrücken der Widerstandselemente und durch Einstellen der Zwischenwerte mittels des variablen Widerstandselements nahezu kontinuierlich einstellen.

$$R_{gesamt} = R_0 + i * R_{einzel} + a * R_{einzel},$$

wobei $R_0$ ein fester Grundwiderstandswert ist, welcher beispielsweise 80% oder mehr des Gesamtwiderstands ausmacht, und wobei $R_{einzel}$ der Widerstandswert der einzelnen überbrückbaren Widerstandselemente ist, also

$$R_{einzel} = (R_{gesamt} - R_0) / N,$$

wobei N-1 die Zahl der überbrückbaren Widerstände ist,
wobei i= 0, 1, ... N-1, und
wobei a = 0 ... 1.

Der Parameter i bezeichnet also die Anzahl der mit ihrem Gesamtwiderstandswert wirksamen Einzelwiderstände, während die Größe a den aktuell wirksamen Anteil des kontunierlich einstellbaren Widerstandselements von seinem Maximalwiderstand $R_{einzel}$ bezeichnet.

Für den Fall, dass kein variables Widerstandselement vorgesehen ist gilt insbesondere:

$$R_{gesamt} = R_0 + i * R_{einzel},$$

mit

$$R_{einzel} = (R_{gesamt} - R_0) / N,$$

wobei N die Zahl der überbrückbaren Widerstände ist, und
wobei i= 0, 1, ... N.

In einer Weiterbildung der Erfindung ist der Widerstandswert über ein Netzwerk von mindestens teilweise überbrückbaren Einzelwiderständen einstellbar, wobei das Netzwerk parallel geschaltete Widerstände und in Serie geschaltete Widerstände umfasst.

In einer Weiterbildung der Erfindung beträgt die erste Frequenz des Referenztaktgebers nicht weniger als 10 Hz, insbesondere nicht weniger als 50 Hz und besonders bevorzugt nicht weniger als 100 Hz. Die Frequenz des Referenztaktgebers beträgt gemäß dieser Weiterbildung der Erfindung nicht mehr als 1 KHz, insbesondere nicht mehr als 500 Hz und besonders bevorzugt nicht mehr als 250 Hz.

Die FLL-Schaltung kann gemäß einer Weiterbildung der Erfindung weiterhin einen Skalierer zur Ausgabe einer dritten Frequenz $f_3$ aufweisen, wobei die dritte Frequenz $f_3$ in einem Verhältnis von N : M zur zweiten Frequenz $f_2$ gegeben ist, also $M * f_3 = N * f_2$.

Die Erfindung wird nun anhand des in den Zeichnungen dargestellten Ausführungsbeispiels erläutert.

Es zeigt:

Fig. 1: eine schematische Darstellung der erfindungsgemäßen Schaltung;

Fig. 2: ein Blockschaltbild zur Steuerung eines programmierbaren Oszillators mittels einer Widerstandskette; und

Fig. 3: ein Blockschaltbild der erfindungsgemäßen Schaltung mit einer Steuerung des programmierbaren Oszillators durch einen FPGA mittels einer Widerstandskette.

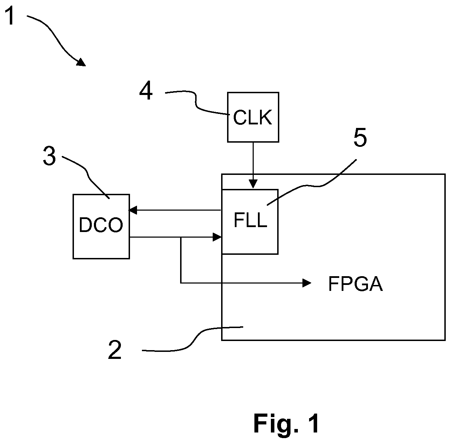

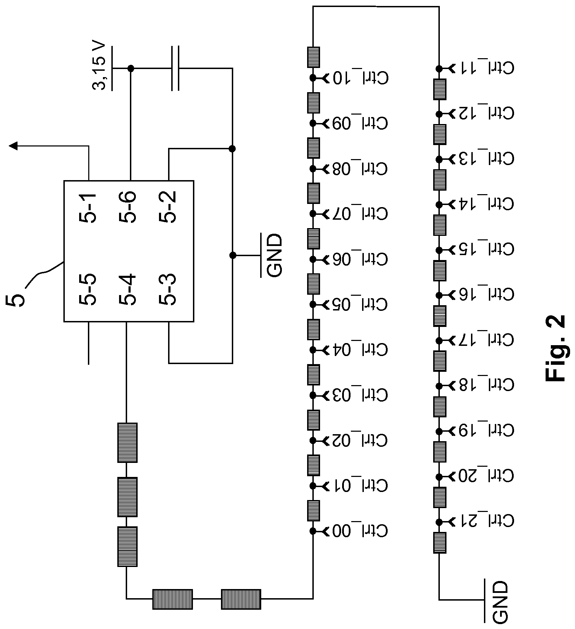

Die in Fig. 1 dargestellte Schaltung 1 umfasst einen FPGA 2, einen programmierbaren Oszillator 3, einen Referenztaktgeber 4 mit einer niedrigen Taktrate und eine FLL-Schaltung 5 (nach dem englischen Frequency Locked Loop), wobei die FLL-Schaltung einerseits den langsamen Takt der Referenztaktgebers 4 und den schnellen Takt des programmierbaren Oszillators 3 empfängt. Der Referenztaktgeber und der programmierbare Oszillator sind externe Bauteile, die an den FPGA angeschlossen sind. Die FLL-Schaltung regelt nun mit einem Zählverfahren den schnelleren Takt des programmierbaren Oszillators in Bezug auf das langsamere Taktsignal des Referenztaktgebers. Dazu werden in einem durch den Referenztakt vorgegebenen Zählfenster die Taktflanken des schnelleren Taktes gezählt und mit einem Sollwert verglichen. Abhängig von dem Vergleichsergebnis wird die Frequenz des programmierbaren Oszillators erhöht oder herabgesetzt. Der programmierbare Oszillator ist im derzeit bevorzugten Ausführungsbeispiel ein über einen externen Widerstand gesteuerter Oszillator mit geringer Leistungsaufnahme, beispielsweise ein LTC 6906. Dieser programmierbare Oszillator kann einen Takt zwischen 10 kHz und 1 MHz generieren, wobei die Stromaufnahme bei einer Versorgungsspannung von etwa 3,15 V und einem Taktsignal von etwa 300 kHz in der Größenordnung von 20 $\mu$A beträgt. Die Beschaltung des programmierbaren Oszillators 3 ist nun in Fig. 2 im Detail erläutert. Die Anschlüsse des programmierbaren Oszillators 5 sind folgendermaßen belegt:

| 5-1: | Taktausgang mit einer Frequenz zwischen 10 kHz und 1 MHz |
| 5-2: | Schaltungsmasse, |
| 5-3: | Teiler |
| 5-4: | Steuereingang und |
| 5-6: | Versorgungsspannungseingang. |

Der Teilereingang 5-3 liegt auf Masse, so dass am Taktausgang 5-1 ein Signal mit ungeteilter Taktfrequenz ausgegeben wird. Am Steuereingang 5-4 ist eine Serienschaltung von Widerstandselementen vorgesehen, welche so gewählt ist, dass ein Zielwert zwischen etwa 300 kHz und etwa 330 kHz, insbesondere etwa 314 kHz als Taktsignal ausgegeben wird. Die Kette von Widerstandselementen weist einige Widerstandselemente auf, die nicht überbrückbar sind und die in Summe einen Widerstandswert von etwa 318 k$\Omega$ aufweisen. Daran schließt sich eine Kette von 22 überbrückbaren Widerständen von jeweils 680 $\Omega$ an. Diese Widerstandselemente sind mittels des FPGA 2 überbrückbar, wobei durch Beschalten eines der Steuereingänge Control 0 bis Control 21 die Widerstandskette ab diesem Steuereingang im Bezug auf Schaltungsmasse überbrückt ist. Damit kann der Gesamtwert des wirksamen Widerstands in diskreten Schritten um bis zu etwa 5 % herabgesetzt werden. Die Zielfrequenz ist im Idealzustand bei etwa 97,5 % des Gesamtwerts erreicht, so dass beispielsweise bei temperaturbedingten Abweichungen oder Abweichungen aufgrund von Fertigungstoleranzen der Widerstandswerte oder des Oszillators durch Schaltung eines anderen Überbrückungspunkts erhöht oder abgesenkt werden kann. Ob der aktuell gewählte Überbrückungspunkt zu hoch oder zu niedrig ist, ergibt sich aus dem Vergleich des Sollwerts der gezählten Taktsignale des programmierbaren Oszillators während einer Taktperiode des Referenztaktgebers.

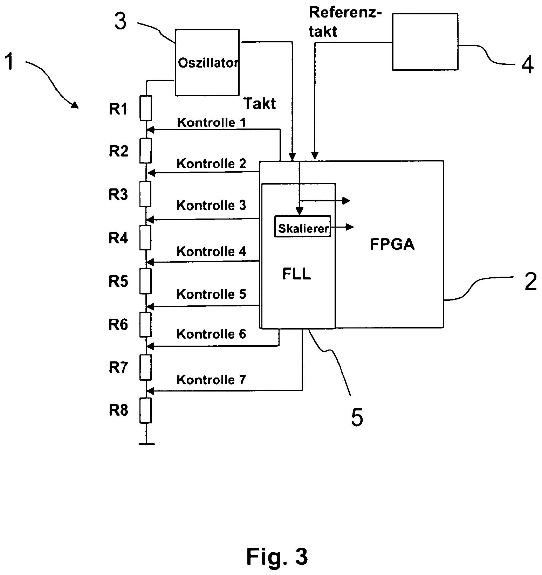

Fig. 3 zeigt eine Gesamtansicht, wobei der Einfachheit halber nur 7 Steuerpunkte Control 1 bis Control 7 dargestellt sind, welche Teile der Widerstandskette überbrücken können.

Als Vorgabewert kann die Widerstandskette beispielsweise zunächst ab dem Steuerpunkt Control 4 überbrückt sein, wobei in Abhängigkeit der Abweichung der gezählten Takte des programmierbaren Oszillators vom Sollwert nach oben oder unten ein anderer Kontrollpunkt aktiviert wird, um die Taktfrequenz zu erhöhen oder abzusenken.

Der Energieaufwand für die Steuerung der Kontrollpunkte und der FLL-Schaltung beträgt etwa 10 $\mu$A (bei einer Versorgungsspannung von 3,15 V), so dass die gesamte Stromaufnahme zur Generierung eines schnellen und hinreichend präzisen Takts etwa 30 $\mu$A bei der vorliegenden Versorgungsspannung beträgt. Dies bedeutet eine Absenkung der Leistungsaufnahme gegenüber den gängigen PLL-Schaltungen, welche einen Stromverbrauch von etwa 1 mA bei der vorliegenden Versorgungsspannung aufweisen, um einen Faktor von mehr als 30.

Naturgemäß bedeutet eine Umschaltung zwischen diskreten Widerstandswerten im Ergebnis, dass das Frequenzsignal des Oszillators einen gewissen Jitter aufweisen wird, wenn die Frequenz nicht zufällig genau bei einer vorgegebenen Widerstandskonstellation erreicht wird. Für den Fall, dass dieser Jitter unerwünscht ist, kann die Widerstandskette noch einen variablen Widerstand aufweisen, dessen Wert kontinuierlich gesteuert wird.

Weiterhin kann anstelle einer Widerstandsreihe mit mehreren Widerstandselementen des gleichen Werts auch ein Widerstandsnetzwerk mit parallel und seriell geschalteten Widerstandselementen eingesetzt werden, mit denen sich auch andere Stufenwerte als ganzzahlige Vielfache eines Widerstandselements darstellen lassen.

Weitere Ausgestaltungen und Abwandlungen der Erfindung ergeben sich für den Fachmann im Umfang der vorliegenden Offenbarung ohne von dem Schutzbereich der folgenden Ansprüche abzuweichen.

**Patentansprüche**

1. Schaltung (1), umfassend:

   einen FPGA (2), welcher eine FLL-Schaltung (5) aufweist;
   einen Referenztaktgeber (4) einer ersten Frequenz oder einen Referenztakteingang zum Empfang eines Referenztakts einer ersten Frequenz;
   einen programmierbaren Oszillator (3), welcher ein Taktsignal für den FPGA (2) ausgibt,
   wobei die FLL-Schaltung (5) dazu ausgelegt ist, eine erste Zahl von Taktsignalen des programmierbaren Oszillators (3) während einer zweiten Zahl von Perioden des Referenztakts zu erfassen,
   wobei die erste Zahl größer ist als die zweite Zahl, und ein Rückkopplungssignal auszugeben, um das Verhältnis zwischen der ersten Zahl und der zweiten Zahl zu steuern, indem das Rückkopplungssignal auf die Frequenz des programmierbaren Oszillators (3) einwirkt,

**dadurch gekennzeichnet, dass**

die Frequenz des programmierbaren Oszillators über mindestens einen Widerstandswert gesteuert wird, auf welchen das Rückkopplungssignal einwirkt, wobei der Widerstandswert einstellbar ist über eine Serie von Einzelwiderständen, die zur Verringerung des Widerstands zumindest teilweise selektiv in Bezug auf Schaltungsmasse überbrückbar sind,

wobei die Serie von überbrückbaren Einzelwiderständen mindestens 10 Einzelwiderstände umfasst.

wobei die Serie der selektiv überbrückbaren Widerstände nicht mehr als 10 % zum gesamten Wert des Widerstands beiträgt.

2. Schaltung nach Anspruch 1,
   wobei die Frequenz des programmierbaren Oszillators durch das Rückkopplungssignal um nicht mehr als 5 %, insbesondere nicht mehr als 2 % und vorzugsweise nicht mehr als 1 % variierbar ist.

3. Schaltung nach Anspruch 1 oder 2,
   wobei die zweite Zahl 1 ist.

4. Schaltung nach einem der Ansprüche 1 bis 3,
   wobei das Verhältnis zwischen der ersten Zahl und der zweiten Zahl einen vorgegebenen Sollwert aufweist, welcher größer als 10:1, vorzugsweise größer als 100:1 und besonders bevorzugt nicht weniger als 500:1 ist.

5. Schaltung nach Anspruch einem der vorhergehenden Ansprüche,
   wobei die Serie von überbrückbaren Einzelwiderständen mindestens mindestens 20 Einzelwiderstände umfasst.

6. Schaltung nach einem der vorhergehenden Ansprüche,
   wobei die Serie von Einzelwiderständen mindestens einen variablen Widerstand umfasst.

7. Schaltung nach einem der vorhergehenden Ansprüche,
   wobei der Widerstandswert über ein Netzwerk von mindestens teilweise überbrückbaren Einzelwiderständen einstellbar ist,
   wobei das Netzwerk parallel geschaltete Widerstände und in Serie geschaltete Widerstände umfasst.

8. Schaltung nach einem der vorhergehenden Ansprüche,
   wobei die erste Frequenz des Referenztakts nicht weniger als 10 Hz, insbesondere nicht weniger als 50 Hz und besonders bevorzugt nicht weniger als 100 Hz beträgt.

9. Schaltung nach einem der vorhergehenden Ansprüche,
   wobei die erste Frequenz des Referenztakts nicht mehr als 1 KHz, insbesondere nicht mehr als 500 Hz und besonders bevorzugt nicht mehr als 250 Hz beträgt.

10. Schaltung nach einem der vorhergehenden Ansprüche,
    wobei die FLL-Schaltung weiterhin einen Skalierer zur Ausgabe einer dritten Frequenz aufweist,
    wobei die dritte Frequenz in einem Verhältnis von N : M zur zweiten Frequenz gegeben ist.

**Claims**

1. Circuit (1) comprising:

   an FPGA (2), which has an FLL circuit (5);
   a reference clock (4) of a first frequency or a reference clock input to receive a reference clock of a first frequency;
   a programmable oscillator (3), which outputs a clock signal for the FPGA (2),
   wherein the FLL circuit (5) is designed to record a first number of clock signals of the programmable oscillator (3) during a second number of periods of the reference clock,
   wherein the first number is greater than the second number, and a feedback signal is output in order to control the ratio between the first number and the second number such that the feedback signal acts on the frequency of the programmable oscillator (3),

**characterized in that**
the frequency of the programmable oscillator is controlled via at least a resistance value on which the feedback signal acts, wherein the resistance value can be regulated via a series of individual resistances which, for the purpose of reducing the resistance, can be bridged at least partially in a selective manner in relation to the circuit ground,
wherein the series of individual resistances that can be bridged comprises at least 10 individual resistances,
wherein the series of individual resistances that can be bridged in a selective manner does not contribute more than 10 % to the total value of the resistance.

2. Circuit as claimed in Claim 1,
wherein the frequency of the programmable oscillator can be varied by the feedback signal by not more than 5 %, particularly not more than 2 % and preferably not more than 1 %.

3. Circuit as claimed in Claim 1 or 2,
wherein the second number is 1.

4. Circuit as claimed in Claims 1 to 3,
wherein the ratio between the first number and the second number has a predefined target value which is greater than 10:1, preferably greater than 100:1 and particularly preferably not less than 500:1.

5. Circuit as claimed in one of the previous claims,
wherein the series of individual resistances that can be bridged comprises at least 20 individual resistances.

6. Circuit as claimed in one of the previous claims,
wherein the series of individual resistances comprises at least one variable resistance.

7. Circuit as claimed in one of the previous claims,
wherein the resistance value can be regulated via a network of individual resistances that can at least partially be bridged,
wherein the network comprises resistances switched in parallel and resistances switched in series.

8. Circuit as claimed in one of the previous claims,
wherein the first frequency of the reference clock is not less than 10 Hz, particularly not less than 50 Hz and particularly preferably not less than 100 Hz.

9. Circuit as claimed in one of the previous claims,
wherein the first frequency of the reference clock is not greater than 1 KHz, particularly not greater than 500 Hz and particularly preferably not greater than 250 Hz.

10. Circuit as claimed in one of the previous claims,
wherein the FLL circuit further comprises a scaling unit to output a third frequency,
wherein the third frequency is defined in a ratio of N : M in relation to the second frequency.

**Revendications**

1. Circuit (1) comprenant :

un composant FPGA (2), lequel comporte un circuit FLL (5) ;
une horloge de référence (4) d'une première fréquence ou une entrée d'horloge de référence pour la réception d'une horloge de référence d'une première fréquence ;
un oscillateur programmable (3), lequel émet un signal d'horloge pour le composant FPGA (2),
le circuit FLL (5) étant conçu à détecter un premier nombre de signaux d'horloge de l'oscillateur programmable (3) pendant un deuxième nombre de périodes de l'horloge de référence,
le premier nombre étant supérieur au deuxième nombre, et un signal de rétroaction étant émis pour contrôler le rapport entre le premier nombre et le deuxième nombre en ce que le signal de rétroaction agit sur la fréquence de l'oscillateur programmable (3),
**caractérisé**

**en ce que** la fréquence de l'oscillateur programmable est commandée par l'intermédiaire d'au moins une valeur de résistance, sur laquelle le signal de rétroaction agit, la valeur de résistance étant réglable au moyen d'une série de résistances individuelles qui, pour la réduction de la résistance, peuvent être pontées au moins partiellement de façon sélective par rapport à la masse du circuit,
la série de résistances individuelles pouvant être pontées comprenant au minimum 10 résistance individuelles, la série de résistances pouvant être pontées de façon sélective ne contribuant pas à plus de 10 % de la valeur totale de la résistance.

2. Circuit selon la revendication 1,
pour lequel la fréquence de l'oscillateur programmable peut être variée par le signal de rétroaction de pas plus de 5 %, notamment pas plus de 2 % et de préférence pas plus de 1 %.

3. Circuit selon la revendication 1 ou 2,
pour lequel le deuxième nombre est égal à 1.

4. Circuit selon l'une des revendications 1 à 3,
pour lequel le rapport entre le premier nombre et le deuxième nombre présente une valeur de consigne prédéfinie, laquelle est supérieure à 10:1, de préférence supérieure à 100:1 et particulièrement de préférence supérieure à 500:1.

5. Circuit selon l'une des revendications précédentes,
pour lequel la série de résistances individuelles pouvant être pontées comprend au minimum 20 résistances individuelles.

6. Circuit selon l'une des revendications précédentes,
pour lequel la série de résistances individuelles comprend au moins une résistance variable.

7. Circuit selon l'une des revendications précédentes,
pour lequel la valeur de résistance est réglable par l'intermédiaire d'un réseau de résistances individuelles pouvant être pontées au moins partiellement,
le réseau comprenant des résistances couplées en parallèle et des résistances couplées en série.

8. Circuit selon l'une des revendications précédentes,
pour lequel la première fréquence de l'horloge de référence n'est pas inférieure à 10 Hz, notamment pas inférieure à 50 Hz et de préférence pas inférieure à 100 Hz.

9. Circuit selon l'une des revendications précédentes,
pour lequel la première fréquence de l'horloge de référence n'est pas supérieure à 1 kHz, notamment pas supérieure à 500 Hz et de préférence pas supérieure à 250 Hz.

10. Circuit selon l'une des revendications précédentes,
pour lequel le circuit FLL comprend en outre un dispositif de comptage pour l'émission d'une troisième fréquence, la troisième fréquence étant définie selon un rapport de N : M par rapport à la deuxième fréquence.

**Fig. 1**

EP 2 569 864 B1

Fig. 2

Fig. 3

EP 2 569 864 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2008144917 A1
- WO 2008132583 A1
- US 5459435 A